# EUROPEAN PATENT APPLICATION

(11) **EP 2 434 855 A2**
(43) Date of publication of application: **28.03.2012**
(21) Application number: 11180670.9
(22) Date of filing: 09.09.2011
(51) Int. Cl.: H05K 7/20

(54) **Method And System For Synthetic Jet Cooling**

(30) Priority: 24.09.2010 US 889804
(71) Applicant: GE Aviation Systems LLC, Grand Rapids, MI 49512-1991 (US)
(72) Inventor: STREYLE, John Jay, Grand Rapids, MI Michigan 49512 (US)
(74) Representative: Williams, Andrew Richard

(57) **Abstract**

A synthetic jet cooling system (100) including a plurality of synthetic jet assemblies (102) configured to be positioned adjacent a component (104) that generates excess heat, each of the plurality of synthetic jet assemblies including a driver (116) configured to excite a respective one of the plurality of synthetic jet assemblies at a varying frequency.

## Description

### BACKGROUND OF THE INVENTION

The field of the invention relates generally to component cooling systems, and more specifically, to a system and method of cooling components using synthetic jets.

At least some known synthetic jet cooling systems produce unacceptably high noise levels at a tone that is irritating to persons in the area when the synthetic jets are driven sufficiently strongly to produce the needed airflow. By driving any one individual synthetic jet at a particular frequency for only a short time, the time-weighted dB level at any particular frequency is lowered. Since the intended usage for the synthetic jet cooling method is primarily avionics, excessive actively-cooled operating noise levels are always a customer and user concern, and may preclude use of synthetic jet cooling method in some applications.

Prior attempts at reducing the noise involved reducing the synthetic jet drive level and alternating the phasing of the jet modules in an array of synthetic jets. However, neither was acceptable, as reducing the drive level reduced the desired air flow; alternating the phasing did not produce a significant change.

### BRIEF DESCRIPTION OF THE INVENTION

In one embodiment, a synthetic jet cooling system includes a plurality of synthetic jet assemblies configured to be positioned adjacent to a component that generates excess heat. Each of the plurality of synthetic jet assemblies includes a driver configured to excite a respective one of the plurality of synthetic jet assemblies at a varying frequency.

In another embodiment, a method of cooling a component includes positioning a plurality of synthetic jet assemblies adjacent a component that generates excess heat and separately driving each of the plurality of synthetic jet assemblies at a frequency that varies between a first frequency limit and a second frequency limit. In yet another embodiment, an electronic component system includes a component enclosure including a plurality of sidewalls defining a volume, a heat generating component positioned within the volume, and a synthetic jet cooling system positioned adjacent the component enclosure. The synthetic jet cooling system includes a plurality of synthetic jet assemblies communicatively coupled to a respective driver configured to excite the synthetic jet assembly at a varying frequency.

### BRIEF DESCRIPTION OF THE DRAWINGS

FIGS. 1-2 show exemplary embodiments of the method and system described herein.
FIG. 1 is a perspective view of a synthetic jet cooling system in accordance with an exemplary embodiment of the present invention; and
FIG. 2 is a flow diagram of a method 200 of cooling a component in accordance with an exemplary embodiment of the present invention.

### DETAILED DESCRIPTION OF THE INVENTION

The following detailed description illustrates embodiments of the invention by way of example and not by way of limitation. It is contemplated that the invention has general application to reducing a perceived noise generated by equipment operating in industrial, commercial, and residential applications.

As used herein, an element or step recited in the singular and proceeded with the word "a" or "an" should be understood as not excluding plural elements or steps, unless such exclusion is explicitly recited. Furthermore, references to "one embodiment" of the present invention are not intended to be interpreted as excluding the existence of additional embodiments that also incorporate the recited features.

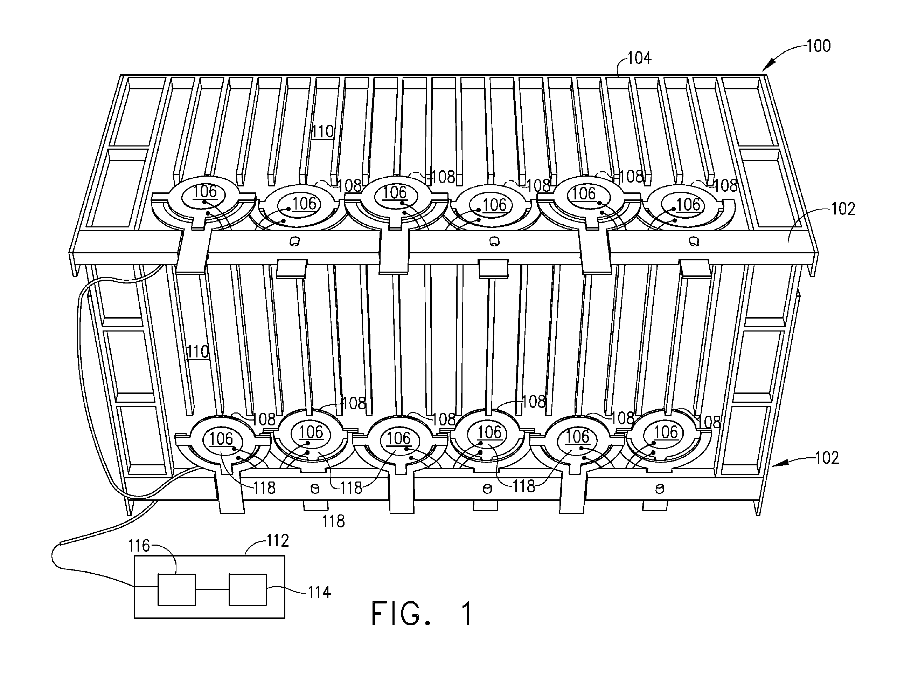

Figure 1 is a perspective view of a synthetic jet cooling system 100 in accordance with an exemplary embodiment of the present invention. In the exemplary embodiment, a plurality of synthetic jet assemblies 102 are configured to be positioned adjacent a component 104 that generates excess heat, such as, but not limited to, an aircraft avionics enclosure. Each of the plurality of synthetic jet assemblies 102 includes at least one synthetic jet ejector 106 that includes a jet port 108. Jet port 108 is aligned at least one of perpendicularly, parallelly, and obliquely with a surface 110 of component 104. Each of the plurality of synthetic jet assemblies 102 includes a controller 112 communicatively coupled to plurality of synthetic jet assemblies 102. In the exemplary embodiment, controller 112 includes a processor 114 programmed to control at least one driver 116 configured to excite a respective one of the plurality of synthetic jet assemblies 102 at a varying frequency. In the exemplary embodiment, driver 116 is communicatively coupled to a piezoelectric actuator 118 associated with a respective synthetic jet assembly 102. Piezoelectric actuator 118 is configured to vibrate such that a flow of fluid is generated, which exits the synthetic jet assembly 102 in a predetermined direction through jet port 108. Driver 116 may be programmable using software and/or firmware to excite synthetic jet assembly 102 or may excite synthetic jet assembly 102 in a fixed manner. Driver 116 may excite synthetic jet assembly 102 at least one of frequency that varies randomly, varies pseudo-randomly, varies linearly, and a combination of the above. Driver 116 may excite synthetic jet assembly 102 at a frequency that varies between a first limit and second limit, the first limit being greater than the second limit.

In one embodiment, component 104 comprises a synthetic jet assembly housing (not shown for clarity) formed integrally with the surface of the component. In various embodiments, synthetic jet assembly 102 comprises a single housing couplable to surface 110 of component 104.

Synthetic jet assemblies 102 are arranged in arrays, as required, to cool electronic equipment, such as, but not limited to, component 104, in lieu of traditional cooling fans, or to augment cooling by natural convection of electronic equipment. Electronic circuits, such as, but not limited to, driver 116 are connected to drive each synthetic jet separately in a predetermined frequency distribution, over the frequency range allowable and useable for the synthetic jet assemblies 102. This reduces the human perceived sound level, and reduces the annoyance factor of the current method.

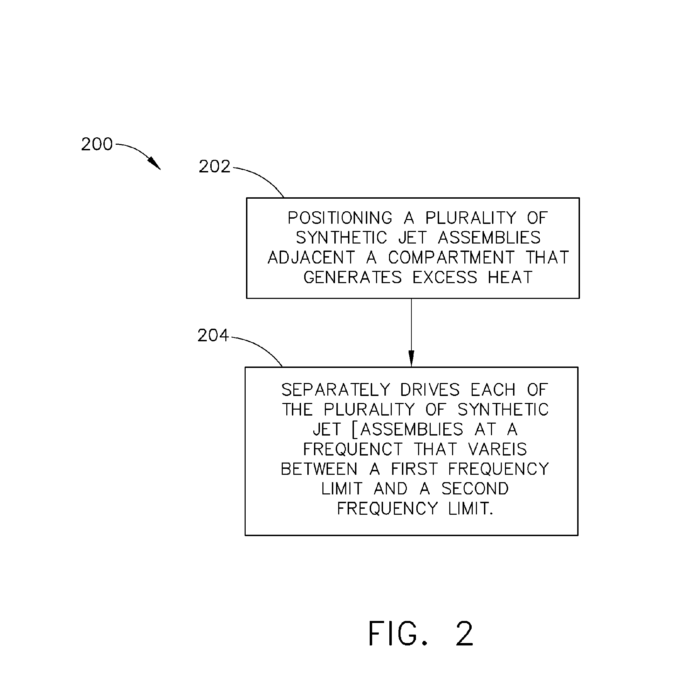

FIG. 2 is a flow diagram of a method 200 of cooling a component in accordance with an exemplary embodiment of the present invention. In the exemplary embodiment, method 200 includes positioning 202 a plurality of synthetic jet assemblies adjacent a component that generates excess heat and separately driving 204 each of the plurality of synthetic jet assemblies at a frequency that varies between a first frequency limit and a second frequency limit.

The term processor, as used herein, refers to central processing units, microprocessors, microcontrollers, reduced instruction set circuits (RISC), application specific integrated circuits (ASIC), logic circuits, and any other circuit or processor capable of executing the functions described herein.

As used herein, the terms "software" and "firmware" are interchangeable, and include any computer program stored in memory for execution by processor 114, including RAM memory, ROM memory, EPROM memory, EEPROM memory, and non-volatile RAM (NVRAM) memory. The above memory types are exemplary only, and are thus not limiting as to the types of memory usable for storage of a computer program.

As will be appreciated based on the foregoing specification, the above-described embodiments of the disclosure may be implemented using computer programming or engineering techniques including computer software, firmware, hardware or any combination or subset thereof, wherein the technical effect is controlling the excitation of a plurality synthetic jet assemblies operating together to cool an electronic component. The excitation is controlled to operate the synthetic jet assemblies at different pseudo- random frequencies, which when combined, produce a perceived noise that is less harsh to a user. Any such resulting program, having computer-readable code means, may be embodied or provided within one or more computer-readable media, thereby making a computer program product, i.e., an article of manufacture, according to the discussed embodiments of the disclosure. The computer readable media may be, for example, but is not limited to, a fixed (hard) drive, diskette, optical disk, magnetic tape, semiconductor memory such as read-only memory (ROM), and/or any transmitting/receiving medium such as the Internet or other communication network or link. The article of manufacture containing the computer code may be made and/or used by executing the code directly from one medium, by copying the code from one medium to another medium, or by transmitting the code over a network.

The above-described embodiments of a method and system of cooling components provides a cost-effective and reliable means for reducing the perceived noise produced by a plurality of synthetic jet air movers. More specifically, the method and system described herein facilitate reducing the perceived noise by driving the synthetic jets at varying pseudo-random distributed frequencies. As a result, the method and system described herein facilitate cooling electronic components in a cost-effective and reliable manner.

This written description uses examples to disclose the invention, including the best mode, and also to enable any person skilled in the art to practice the invention, including making and using any devices or systems and performing any incorporated methods. The patentable scope of the invention is defined by the claims, and may include other examples that occur to those skilled in the art. Such other examples are intended to be within the scope of the claims if they have structural elements that do not differ from the literal language of the claims, or if they include equivalent structural elements with insubstantial differences from the literal languages of the claims.

Various aspects of the invention are outlined in the following clauses:
1. A synthetic jet cooling system comprising a plurality of synthetic jet assemblies configured to be positioned adjacent a component that generates excess heat, each of the plurality of synthetic jet assemblies comprising a driver configured to excite a respective one of the plurality of synthetic jet assemblies at a varying frequency.
2. A synthetic jet cooling system in accordance with clause 1, wherein each of the plurality of synthetic jet assemblies includes at least one synthetic jet ejector comprising a piezoelectric actuator, said actuator configured to vibrate such that a flow of fluid is generated.
3. A synthetic jet cooling system in accordance with either of clause 1 or 2, wherein said driver is configured to excite a respective one of the plurality of synthetic jet assemblies at a frequency that varies randomly.
4. A synthetic jet cooling system in accordance with either of clause 1 or 2, wherein said driver is configured to excite a respective one of the plurality of synthetic jet assemblies at a frequency that varies pseudo-randomly.
5. A synthetic jet cooling system in accordance with either of clause 1 or 2, wherein said driver is configured to excite a respective one of the plurality of synthetic jet assemblies at a frequency that varies linearly
6. A synthetic jet cooling system in accordance with either of clause 1 or 2, wherein said driver is configured to excite a respective one of the plurality of synthetic jet assemblies at a frequency that varies between a first limit and second limit, the first limit being greater than the second limit.
7. A synthetic jet cooling system in accordance with any one of the preceding clauses, wherein each of the plurality of synthetic jet assemblies includes at least one synthetic jet ejector comprising a jet port, said jet port aligned at least one of perpendicularly, parallelly, and obliquely with a surface of the component.
8. A synthetic jet cooling system in accordance with any one of the preceding clauses, wherein said component comprises a synthetic jet assembly housing formed integrally with the surface of the component.
9. A synthetic jet cooling system in accordance with any one of clauses 1 to 7, wherein said synthetic jet assembly comprises a plurality of synthetic jet ejectors enclosed in a single housing.
10. A synthetic jet cooling system in accordance with any one of clauses 1 to 7, wherein said synthetic jet assembly comprises a single housing couplable to the surface of the component.
11. A method of cooling a component, said method comprising:
   positioning a plurality of synthetic jet assemblies adjacent a component that generates excess heat; and
   separately driving each of the plurality of synthetic jet assemblies at a frequency that varies between a first frequency limit and a second frequency limit.
12. A method in accordance with clause 11 wherein separately driving each of the plurality of synthetic jet assemblies comprises separately driving each of the plurality of synthetic jet assemblies at a frequency that varies over time.
13. A method in accordance with clause 11 wherein separately driving each of the plurality of synthetic jet assemblies comprises separately driving each of the plurality of synthetic jet assemblies at a frequency that varies randomly.
14. A method in accordance with clause 11 wherein separately driving each of the plurality of synthetic jet assemblies comprises separately driving each of the plurality of synthetic jet assemblies at a frequency that varies pseudo-randomly such that a first audio noise generated by each of the plurality of synthetic jet assemblies is combined to a second audio noise, the second audio noise being perceived by a user as less annoying then the first audio noise.
15. A method in accordance with clause 11 wherein separately driving each of the plurality of synthetic jet assemblies comprises:
   communicatively coupling a piezoelectric driver to a respective one of the plurality of synthetic jet assemblies;
   generating an electrical signal in each of the piezoelectric drivers that is different from the electrical signals generated in the other piezoelectric drivers; and
   transmitting the generated electrical signals to the respective synthetic jet assemblies such that each of the plurality of synthetic jet assemblies is excited at a different frequency.
16. An electronic component system comprising:
   a component enclosure comprising a plurality of sidewalls defining a volume;
   a heat generating component positioned within the volume; and
   a synthetic jet cooling system positioned adjacent the component enclosure, the synthetic jet cooling system comprising a plurality of synthetic jet assemblies communicatively coupled to a respective driver configured to excite the synthetic jet assembly at a varying frequency.
17. An electronic component system in accordance with clause 16, wherein each of the plurality of synthetic jet assemblies includes at least one synthetic jet ejector comprising a piezoelectric actuator, said actuator configured to vibrate such that a flow of fluid is generated.
18. An electronic component system in accordance with either of clause 16 or 17, wherein said driver is configured to excite a respective one of the plurality of synthetic jet assemblies at a frequency that varies randomly.
19. An electronic component system in accordance with either of clause 16 or 17, wherein said driver is configured to excite a respective one of the plurality of synthetic jet assemblies at a frequency that varies pseudo-randomly.
20. An electronic component system in accordance with either of clause 16 or 17, wherein said driver is configured to excite a respective one of the plurality of synthetic jet assemblies at a frequency that varies between a first limit and second limit, the first limit being greater than the second limit.

## Claims

1. A synthetic jet cooling system (100) comprising a plurality of synthetic jet assemblies (102) configured to be positioned adjacent a component (104) that generates excess heat, each of the plurality of synthetic jet assemblies comprising a driver (116) configured to excite a respective one of the plurality of synthetic jet assemblies at a varying frequency.

2. A synthetic jet cooling system (100) in accordance with claim 1, wherein each of the plurality of synthetic jet assemblies (102) includes at least one synthetic jet ejector (106) comprising a piezoelectric actuator (118), said actuator configured to vibrate such that a flow of fluid is generated.

3. A synthetic jet cooling system (100) in accordance with either of claim 1 or 2, wherein said driver (116) is configured to excite a respective one of the plurality of synthetic jet assemblies (102) at a frequency that varies randomly.

4. A synthetic jet cooling system (100) in accordance with either of claim 1 or 2, wherein said driver (116) is configured to excite a respective one of the plurality of synthetic jet assemblies (102) at a frequency that varies pseudo-randomly.

5. A synthetic jet cooling system (100) in accordance with either of claim 1 or 2, wherein said driver (116) is configured to excite a respective one of the plurality of synthetic jet assemblies (102) at a frequency that varies linearly

6. A synthetic jet cooling system (100) in accordance with either of claim 1 or 2, wherein said driver (116) is configured to excite a respective one of the plurality of synthetic jet assemblies (102) at a frequency that varies between a first limit and second limit, the first limit being greater than the second limit.

7. A synthetic jet cooling system (100) in accordance with any one of the preceding claims, wherein each of the plurality of synthetic jet assemblies (102) includes at least one synthetic jet ejector (106) comprising a jet port (108), said jet port aligned at least one of perpendicularly, parallelly, and obliquely with a surface (110) of the component.

8. A synthetic jet cooling system (100) in accordance with any one of the preceding claims, wherein said component (104) comprises a synthetic jet assembly housing formed integrally with the surface (110) of the component.

9. A synthetic jet cooling system (100) in accordance with any one of claims 1 to 7, wherein said synthetic jet assembly (102) comprises a plurality of synthetic jet ejectors (106) enclosed in a single housing.

10. A synthetic jet cooling system (100) in accordance with any one of claims 1 to 7, wherein said synthetic jet assembly (102) comprises a single housing couplable to the surface (110) of the component (104).

11. A method (200) of cooling a component (104), said method comprising:
positioning (202) a plurality of synthetic jet assemblies (102) adjacent a component (104) that generates excess heat; and
separately driving (204) each of the plurality of synthetic jet assemblies at a frequency that varies between a first frequency limit and a second frequency limit.

12. A method (200) in accordance with Claim 11, wherein separately driving (204) each of the plurality of synthetic jet assemblies (102) comprises separately driving each of the plurality of synthetic jet assemblies at a frequency that varies over time.

13. A method (200) in accordance with Claim 11, wherein separately driving (204) each of the plurality of synthetic jet assemblies (102) comprises separately driving each of the plurality of synthetic jet assemblies at a frequency that varies randomly.

14. A method (200) in accordance with Claim 11, wherein separately driving (204) each of the plurality of synthetic jet assemblies (102) comprises separately driving each of the plurality of synthetic jet assemblies at a frequency that varies pseudo-randomly such that a first audio noise generated by each of the plurality of synthetic jet assemblies is combined to a second audio noise, the second audio noise being perceived by a user as less annoying then the first audio noise.

15. A method (200) in accordance with Claim 11, wherein separately driving (204) each of the plurality of synthetic jet assemblies (102) comprises:
communicatively coupling a piezoelectric driver (116, 118) to a respective one of the plurality of synthetic jet assemblies;
generating an electrical signal in each of the piezoelectric drivers that is different from the electrical signals generated in the other piezoelectric drivers; and
transmitting the generated electrical signals to the respective synthetic jet assemblies such that each of the plurality of synthetic jet assemblies is excited at a different frequency.
